Europäisches Patentamt

European Patent Office

Office européen des brevets

(11) Veröffentlichungsnummer: **0 430 874 A1**

# (12) EUROPÄISCHE PATENTANMELDUNG

(21) Anmeldenummer: 90810863.2

(22) Anmeldetag: 09.11.90

(51) Int. Cl.5: **C23C 14/02**, C23C 14/06, C23C 14/18, C23C 14/32

(30) Priorität: 22.11.89 CH 4191/89

(43) Veröffentlichungstag der Anmeldung:
05.06.91 Patentblatt 91/23

(84) Benannte Vertragsstaaten:
CH DE ES FR GB IT LI Patentblatt 1

(71) Anmelder: BALZERS AKTIENGESELLSCHAFT

FL-9496 Balzers(LI)

(72) Erfinder: **Schulz, Hans Dr.**
Alte Churerstrasse 792
9496 Balzers(LI)
Erfinder: **Daxinger, Helmut**
Melserstrasse
7323 Wangs(CH)
Erfinder: **Bergmann, Erich Dr.**
Sarganserstrasse 58
8887 Mels(CH)
Erfinder: **Ramm, Jürgen Dr.**
Unterdorf 72b
7306 Flaesch(CH)

(74) Vertreter: **Keller, René, Dr. et al**
Patentanwälte Dr. René Keller & Partner
Postfach 12 Marktgasse 31
CH-3000 Bern 7(CH)

(54) **Gegenstand mit einer Dekorschicht.**

(57) Ein beschichteter Gegenstand (1) mit einer Dekorschicht (7) hat auf seinem Grundkörper (3) eine mit einem PVD-Verfahren aufgebrachte Trennschicht (9) aus einem keramischen, elektrisch nicht leitendem Material, über der die Dekorschicht (7) liegt. Die Dekorschicht (7) kann je nach Verwendungszweck aus einer Hartstoffschicht (6) und einer farbtonbestimmenden Schicht 5 bestehen. Die Beschichtung ist abrasionsresistent und schützt den Grundkörper (3) vor Korrosion.

Die erfindungsgemäße Beschichtung hat eine ausgezeichnete Resistenz gegenüber Körperschweiß. Auch bei Langzeitversuchen im Salznebelsprühtest wurden keine Schichtablösungen beachtet. Die Beschichtung ist überall dort vorteilhaft anzuwenden, wo der beschichtete Gegenstand direkt auf der menschlichen Haut getragen wird, wie insbesondere bei Uhrenarmbändern und Uhrengehäusen.

Fig. 1

## GEGENSTAND MIT EINER DEKORSCHICHT.

Die Erfindung betrifft einen Gegenstand mit einer Dekorschicht gemäß dem Oberbegriff des Patentanspruchs 1, ein Verfahren zu dessen Herstellung, gemäß dem Oberbegriff des Patentanspruchs 11 sowie die Verwendung des Verfahrens gemäß dem Oberbegriff des Patentanspruchs 16.

In der Schmuckindustrie hergestellte Gegenstande dieser Art, wie z.B. Armbänder aus Messing oder Stahl, sind gemäß der US-PS 4,533,605 mit einer Haftschicht aus z. B. Nickel direkt auf der Oberfläche des Gegenstands beschichtet, um deren rauhe Oberfläche zu glätten. Auf dieser Haftschicht liegt eine Dekorschicht, insbesondere eine Gold- oder Silberschicht, über der eine Schutzschicht aus einem dünnen, farblosen, nicht metallischen Film angeordnet ist. Die Schutzschicht ist bedeutend härter als das reine Edelmetall und besteht aus Aluminiumoxid ($AlO_2$ oder $Al_2O_3$), Titandioxid ($TiO_2$), Aluminiumnitrid ($Al_3N_4$), Magnesiumoxid ($MgO$), Spinell ($MgO \cdot 3,5 \cdot Al_2O_3$) oder aus Corning-Glass (z. B. No. 0080, 7070, 7740 oder 7059). Durch die transparente Schutzschicht wird die Knoop-Härte der beschichteten Oberfläche je nach verwendetem Material um einem Faktor 3 bis 19 erhoht. Neben den oben erwähnten Materialien wurden Aluminiumkarbid ($AlC$) und dielektrische Materialien, wie, Tantaloxid ($Ta_2 O_5$), Nioboxid ($Nb_2O_5$) und Germaniumoxid ($GeO_2$) als Schutzschicht verwendet. Der Brechungsindex der verwendeten Materialien liegt zwischen 1,4 und 2,8. Wie in der US PS 4,533,605 dargetan, treten bei Schichtdicken von 500 bis 15 000 Å zufolge des auf die Oberfläche einfallenden Lichts unschöne Interferenzerscheinungen an der Schutzschicht auf. Zur Vermeidung dieser Interferenzerscheinungen wird im Verhältnis zur Lichtwellenlänge eine sehr dicke (größer 15 000 Å) Schutzschicht aus einem Material mit einem optischen Brechungsindex größer 2 vorgeschlagen. Wie in der US-PS 4,533,605 dargetan, neigen solche dicken Schutzschichten mit Schichtdicken größer 15 000 Å allerdings zu Rißbildungen, worauf sie vom Gegenstand abfallen. Zur Vermeidung von Interferenzerscheinungen sehr dünn ausgeführte Schutzschichten (dünner als 500 Å), gewährleisten demgegenüber keinen ausreichenden Abrasionsschutz. Zur Vermeidung der Interferenzerscheinungen und zur Erreichung eines ausreichenden Langzeitabrasionswiderstands wird in der US-PS 4,533,60 schließlich vorgeschlagen, mittels eines sehr aufwendigen Beschichtungsvorganges bis zu vierzig dünne (100 Å dicke) alternierende Schichten von Gold als Dekorschicht und $AlO_2$ als Schutzschicht aufzubringen, wobei die äußerste Schicht eine $AlO_2$-Schutzschicht ist, und die innerste Goldschicht auf dem Substrat (bzw. einer auf das Substrat aufgebrachten Haftschicht) liegt.

Die Schutzschicht schützt zwar die Dekorschicht gegenüber Abrasion und einem chemischen Angriff, insbesondere bei Silber und Messing, sie erlaubt es auch nur dünne Edelmetallschichten zu verwenden, der natürliche typisch matte Gold- und Silberglanz aber, wie er sich durch geringfügigste Verkratzungen ergibt, ist jedoch nicht mehr vorhanden. Der mit obiger Beschichtung vergütete Gegenstand erhält hierdurch ein "zu perfektes", künstliches Aussehen, dem ein farblich schillernder Glanz überlagert ist. Namentlich wenn die Schutzschicht aus einem Material mit hohem Brechungsindex besteht, treten zudem starke optische Dispersion und große Unterschiede in der wellenlängenabhängigen Absorption auf, wodurch der Farbcharakter der darunterliegenden Dekorschicht verändert wird.

Die Schutzschicht schützt zwar aufgrund ihrer Härte die unter ihr liegende Edelmetallschicht. Erfährt jedoch der mit der bekannten Beschichtung versehende Gegenstand einen kräftigen Schlag oder wird er stark angeschlagen, so erleidet die Schutzschicht am Auftreffpunkt sichtbare Sprünge oder eine milchige Trübung aufgrund einer Vielzahl kleiner Risse.

In der Schmuckindustrie hergestellte Gegenstände anderer Art, haben eine goldfarbene, harte äußerste Schicht, die als Dekorschicht wirkt und ein Ersatz für teueres Goldplattieren darstellen soll. Diese goldfarbene Schicht besteht in der Regel aus Nitriden der Elemente Titan, Zirkon, Hafnium, Vanadium, Niob, Tantal, Chrom, Molybdän oder Wolfram. Sie werden direkt auf dem zu beschichtenden Gegenstand, wie in der DE-OS 37 28 836 beschrieben, oder wie in der US-PS 4,557,981 dargelegt auf einer harten Metallschicht z. B. aus einer Nickel-Bor-Legierung, einer Kobalt-ChromWolfram-Legierung, Molybdän usw., die direkt auf der Oberfläche des Gegenstands liegt, aufgebracht.

Es hat sich nun gezeigt, daß diese Dekorschicht zwar äußerst resistent gegenüber Abrasion ist, aber im Laufe der Zeit, insbesondere wenn der Gegenstand in einer für sein Grundmaterial agressiven, korrosiven Umgebung eingesetzt wird, abblättert. Dies gilt insbesondere für Gegenstände aus Rostfreistahl, die mit Körperschweiß oder Meerwasser in Berührung kommen.

Der Erfindung liegt die Aufgabe zugrunde eine haltbare, einfach herstellbare, dekorative Beschichtung auf einem Gegenstand zu schaffen, die auch in einer für das Grundmaterial des Gegenstands agressiven, korrosiven Umgebung eine lange Lebensdauer bei verminderter Abrasion ergibt.

Die erfindungsgemäße Losung der Aufgabe ist hinsichtlich des Gegenstands durch die im Anspruch 1, hinsichtlich des Verfahrens durch die im Anspruch 11 und hinsichtlich der Verwendung des Verfahrens durch die im Anspruch 16 angegebenen Merkmale gekennzeichnet.

Die Ansprüche 2 bis 10 beschreiben bevorzugte Ausführungsformen des erfindungsgemäßen Gegenstands und die Ansprüche 12 bis 15 bevorzugte Ausführungsarten des erfindungsgemäßen Verfahrens.

Im folgenden wird ein Beispiel des erfindungsgemäßen Gegenstands und des erfindungsgemäßen Verfahrens zur Beschichtung des Gegenstands sowie der Verwendung des Verfahrens anhand von zeichnerischen Darstellungen näher erläutert. Es zeigen:

Fig. 1 einen Schnitt durch eine schematische Darstellung einer Beschichtung eines Gegenstands mit einer Dekor und einer Trennschicht,

Fig. 2 einen Schnitt durch eine Variante der in **Figur 1** dargestellten Beschichtung,

Fig. 3 einen Schnitt durch eine schematische dargestellte Aufdampfanlage,

Fig. 4 einen Schnitt durch die Aufdampfanlage in Figur 3 entlang der Linie IV - IV, wobei aufgrund einer vorhandenen Rotationssymmetrie nur eine Hälfte der Aufdampfanlage dargestellt ist, und

Fig. 5 einen Schnitt durch eine weitere Variante der in **Figur 1** dargestellten Beschichtung.

Schmuckgegenstände, Brillengestelle, Uhrengehäuse, Uhrenarmbänder, repräsentative Schreibutensilien, Toilettenartikel, Warm- und Kaltwasserarmaturen, etc. werden zur Verschönerung mit einer dekorativ aussehenden Oberfläche versehen; auch werden modische Farben in verschiedenen Farbschattierungen und Glanzeffekten erzeugt.

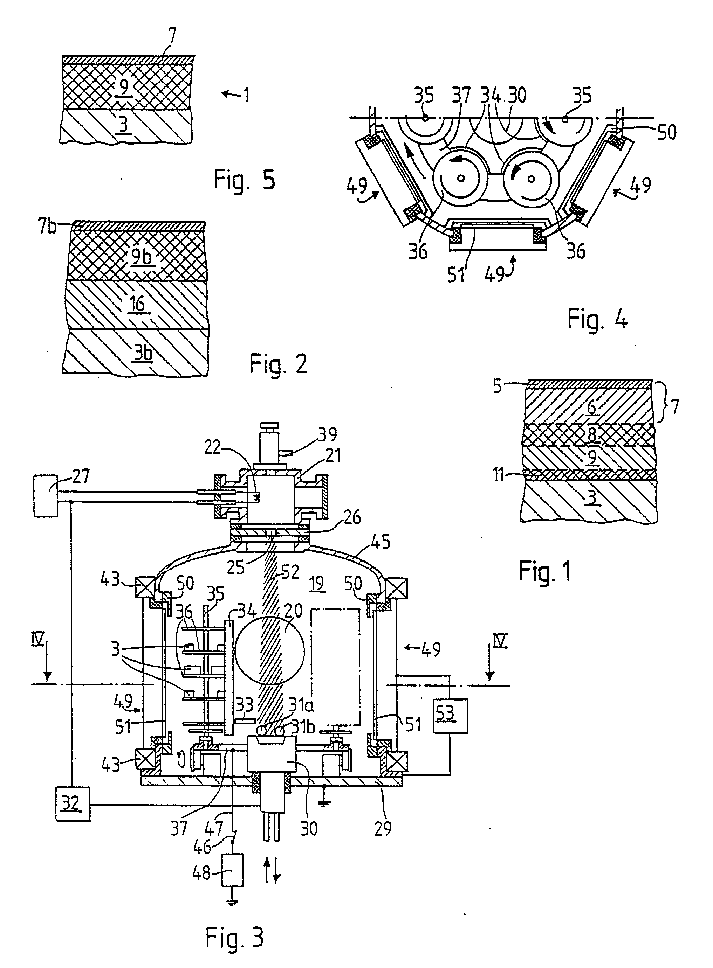

Überraschenderweise hat sich bei Beanspruchungstests der erfindungsgemäß beschichteten Gegenständen 1 mit einem Grundkörper 3 aus Eisenmetallen, Kupfer oder Aluminium, bzw. deren Legierungen in einer für diesen chemisch agressiven Umgebung ergeben, daß die erfindungsgemäße dekorative Beschichtung eine ausgezeichnete Beständigkeit und einen hohen Abrasionswiderstand gegenüber den bekannten, dekorativen Beschichtungen aufweist, wenn die in **Figur 1** dargestellte Dekorschicht 7 über einer Trennschicht 9 aus elektrisch nicht leitendem, keramischem Material über der Oberfläche des Grundkörpers 3 liegt. Die nach dem unten beschriebenen erfindungsgemäßen Verfahren aufgebrachte Trennschicht 9 ist röntgenamorph, d. h. sie zeigt bei Bestrahlung mit einem Röntgenstrahl auf der der Röntgenquelle abgewandten Seite der Trennschicht 9 nur eine annähernd gaußsche Intensitätsverteilung mit einem Strahlungsmaxima in der Strahlmitte; es ist keine Fernfeldordnung (kein Debye-Scherrer-Diagramm) zu erkennen.

Die Dekorschicht 7 als oberste Schicht besteht aus einer Hartstoffschicht 6 aus Titannitrid TiN, über der eine dünne farbtonbestimmende Schicht 5 aus einer Goidlegierung liegt. Je nach Verwendungszweck liegt die die Schichtdicke der Hartstoffschicht 6 zwischen 0,6 und 2 $\mu$m und die der farbtonbestimmenden Schicht 5 zwischen 0,05 und 0,5 $\mu$m. Die Dekorschicht 7 ergibt keine störenden Interferenzerscheinungen wie bei der in der US-PS 4,533,605 beschriebenen bekannten dekorativen Beschichtung.

Die Trennschicht 9 besteht aus einem elektrisch nicht leitenden, keramischen Material, dessen Schichtdicke je nach verwendetem Material und Einsatzgebiet zwischen 0,2 und 1 $\mu$m liegt. Unter einem keramischen Material wird eine chemische Verbindung verstanden, die in ihrer soliden Form als Keramik bekannt ist, d. h. der Aufbau der Trennschicht 9 kann somit auch amorph sein. Die Trennschicht 9 enthält im wesentlichen Aluminiumoxid $Al_2O_3$, wie unten beschrieben.

Das Material der Trennschicht 9 geht in einer Übergangsschicht 8 allmählich in das Material der Hartstoffschicht 6 über. Ebenfalls geht die Trennschicht 9 zum Grundkörper 3 hin allmählich in einer weiteren Übergangsschicht 11 in Aluminium, dem Bindungspartner des Aluminiumoxids des Materials der Trennschicht 9, über.

**Figur 3** zeigt eine schematische Darstellung einer beispielsweisen Aufdampfanlage zur Durchführung der erfindungsgemäßen dekorativen Beschichtung. Die Aufdampfanlage hat eine Vakuumkammer 19 mit einem Evakuierungsanschluß 20 und eine Glühkathodenkammer 21 mit einer Glühkathode 22, die über eine Öffnung 25 mit der Vakuumkammer 19 verbunden ist. Der die Öffnung 25 beinhaltende Boden 26 der Glühkathodenkammer 21 ist gegenüber den Wänden der Vakuumkammer 19 elektrisch isoliert. Die Glühkathode 22 wird von einem Stromversorgungsgerät 27 gespeist. Unterhalb der Öffnung 25 befindet sich über dem Boden 29 der Vakuumkammer 19 ein Tiegel aus Titan, in dem Aluminium 31a als Oxidbildner und Titan 31b als Nitridbildner liegen. Der Titantiegel, sog. Titanliner, steht in einem kühlbaren Kupfertiegel. Diese Anordnung wird nachfolgend als Tiegel 30 bezeichnet. Der Titanliner sorgt einerseits für eine Wärmeisolation gegenüber den Kupfertiegel und erleichtert die Legierbarkeit von Aluminium mit Titan, um die Viskosität und die Reaktivität beim späteren Verfahrensablauf gegenüber Sauerstoff günstig zu beeinflussen. Das Aluminium 31a und Titan 31b sind mit einer verschiebbaren Blende 33 abdeckbar. In der Vakuumkammer 19 sind sechs um die Längsachse drehbare, elektrisch leitende Träger 35, von denen vier in **Figur 4** angedeutet sind, vorhanden, an denen die zu beschichtenden Grundkörper 3 aus Stahl an je einer Halterung 36 gehalten werden. Die Träger 35 sind um ihre Achse drehbar auf einem Drehteller 37 angeordnet und durch diesen untereinander elektrisch verbunden. Der Drehteller 37 ist gegenüber dem Boden 29 und den Wänden der Vakuumkammer 19 elektrisch isoliert. Die Halterungen 36 sind mit den Trägern 35 elektrisch leitend verbunden. Die an den Halterungen 36 gehaltenen Grundkörper 3 sind mit einer in **Figur 3** und **4** schematisch dargestellten Blende 34 gegenüber dem Aluminium und Titan 31a und 31b im Tiegel 30 abdeckbar.

In die Glühkathodenkammer 21 mündet eine Gaszuleitung 39, die über die Öffnung 25 mit der Vakuumkammer 19 verbunden ist. Je eine schematisch dargestellte Magnetspule 43 befindet sich gerade oberhalb des Bodens 29 und am Anschluß eines Deckelteils 45 der Vakuumkammer 19 zur Erzeugung eines annähernd parallelen vertikalen Magnetfelds.

Der Drehteller 37 ist über eine elektrische Leitung 47 und einen geschlossenen Schalter 46 mit einem einstellbaren Spannungsgenerator 48, dessen anderer Pol geerdet ist, verbunden.

In den vertikalen Wänden der Vakuumkammer 19 sind sechs Vorrichtungen 49 zur Kathodenzerstäubung angeordnet, von denen drei in **Figur 4** dargestellt sind. Die Vorrichtung 49 ist mit einem nicht dargestellten Wärmetauscher zur Kühlung versehen. Innerhalb eines Rings 50 liegt ein von ihm isoliertes Target 51 aus einer Goldlegierung, welches mit dem negativen Pol einer Spannungsquelle 53 verbunden ist. Der positive Pol der Spannungsquelle 53 ist mit den Wänden der Vakuumkammer 19 und dem Ring 50 verbunden. Die Glühkathode 22 und der Tiegel 30 sind über elektrische Leitungen mit einem Stromversorgungsgerät 32 verbunden.

Zur Herstellung der obigen Beschichtung werden die Grundkörper 3 an den Halterungen 36 der Träger 35 befestigt und Aluminium und Titan 31a und 31b in den Tiegel 30 gelegt. Anschließend wird die Vakuumkammer 19 geschlossen, auf einen Druck von 2 mPa evakuiert und die zu beschichtenden Oberflächen der Gegenstände 3 entsprechend einem in der DE-OS 34 06 953 bzw. der CH-PS 658 545 beschriebenen Verfahren mit einem Niedervoltbogen 52 auf **450** °C erhitzt und entsprechend einem in der CH-PS 631 743 beschrieben Verfahren gereinigt. Die Blende 33 bedeckt währenddessen das Aluminium und Titan 31a und 31b im Tiegel 30.

In der Vakuumkammer 19 wird Argon eingeleitet und dessen Druck auf 0,15 Pa eingestellt. Die Blende 33 wird entfernt und der Niedervoltbogen 52 zum Tiegel 30 gezündet. Bei einem Strom des Niedervoltbogens 52 von **80** A erfolgt ein Legieren von Aluminium 31a und Titan 31b ohne eine wesentliche Verdampfung des Aluminiums. Nach etwa vier Minuten ist dieser Vorgang abgeschlossen, die Blende 34 vor den Trägern 35 wird weggeklappt und der Strom des Niedervoltbogens 52 wird auf **120** A erhöht, um Aluminium zu verdampfen. Aufgrund des hohen Unterschiedes von fünf Größenordnungen der Dampfdrücke von Aluminium und Titan wird kein Titan verdampft. Innerhalb der nächsten vier Minuten wird Aluminium ohne Zusatz eines Reaktivgases verdampft und direkt auf der Oberfläche des Grundkörpers 3 als unterster Bereich der Übergangsschicht 11 niedergeschlagen.

Innerhalb der nun folgenden zwei Minuten wird Sauerstoff durch die Gaszuleitung 39 mit steigender Zuflußmenge eingelassen und ein Gesamtdruck in der Vakuumkammer 19 von 0,4 Pa eingestellt. Der Sauerstoff wird durch den Niedervoltbogen 52 teilweise ionisiert. Der teilweise ionisierte Sauerstoff und das teilweise ionisierte Aluminium vereinigen sich auf der Oberfläche des Grundkorpers zu $Al_2O_3$ und bleiben auf ihr haften. Je nach der vorhanden Menge Sauerstoff ändert sich das Verhältnis der niedergeschlagenen Menge Aluminiumoxid zum Aluminium. Der Sauerstoffzufluß beträgt bei obigem Enddruck 200 Standardkubikzentimeter pro Minute. Damit die Verdampfungsrate des Aluminiums durch dessen Verbrauch nicht absinkt, wird durch eine nicht dargestellte Stromregelung der Strom des Niedervoltbogens 52 hochgeregelt.

Innerhalb der folgenden fünfzehn Minuten ist der Strom des Niedervoltbogens 52 bis auf 200 A hochgeregelt und ein wesentlicher Teil des Aluminiums verdampft. Nun wird die Sauerstoffzufuhr derart stetig reduziert und eine Stickstoffzufuhr derart stetig erhöht, daß obiger Druck von 0,4 Pa in der Vakuumkammer 19 erhalten bleibt. Dieser Verfahrensschritt dauert fünf Minuten und die Übergangsschicht 8 aus $Al_xTi_yO_uN_v$ zwischen der Trennschicht 9 und der noch herzustellenden Hartstoffschicht 6 der Dekorschicht 7 ist fertig, wobei die Werte für x und u mit wachsender Übergangsschicht 8 ab- und die Werte für y und v zunehmen. Die aufgebrachte Trennschicht 9 hat eine Dicke von 1 μm.

Während nun folgender dreißig Minuten wird mit dem Niedervoltbogen 52 Titan aus dem Tiegel 30 in der Stickstoffatmosphäre verdampft und auf der Übergangsschicht 8 die Titannitrid-Hartstoffschicht 6 niedergeschlagen. Danach wird der Niedervoltbogen 52 und die Stickstoffzufuhr abgeschaltet.

Zur Herstellung der farbtonbestimmenden Schicht 5 der Dekorschicht 7 wird die Spannungsquelle 53 eingeschaltet und hierdurch der Vorgang des Sputterns der Goldlegierung vom Target 51 in Gang gesetzt. Die Grundkörper 3 sind elektrisch floatend. Ist eine Goldlegierungsschichtdicke von 0,1 μm auf der Hartstoffschicht 6 niedergeschlagen, wird die Spannungsquelle **53** ausgeschaltet. Die Vakuumkammer **19** wird geflutet und anschließend zur Entnahme der dekorativ beschichteten Gegenstände **1** geöffnet.

Die farbtonbestimmende Schicht **5** kann auch zusammen mit der Hartstoffschicht **6** aufgebracht werden, d.h. der Sputtervorgang wird eingeschaltet, wenn z. B. die restlichen 0,1 μm der Hartstoffschicht **6** aufgebracht werden. Anstelle einer Goldlegierung lassen sich auch andere Materialien als farbtonbestimmende Schicht **5** aufsputtern, wie z. B. Silber oder TiOCN für einen schwarzen Belag. Auch kann das Material der farbtonbestimmende Schicht **5** mittels Ionenplattieren mit dem Niedervoltbogen **52** anschließend an das Verdampfen von Titan verdampft werden. Anstelle von Titan können auch andere Metalle verdampft werden, die dann anstelle in einer Stickstoffatmosphäre in einer Sauerstoffatmosphäre zu farbigen Metalloxiden oxidiert werden.

Als farbtonbestimmende Schicht **5** werden hauptsächlich Goldlegierungs- und Silberschichten mit einer Schichtdicke von mindestens 100 Å verwendet.

Als Dekosschicht **7** können auch goldfarbene Verbundbeschichtungen im wesentlichen aus Nitriden der Elemente der Gruppe IVb (Titan, Zirkon, Hafnium) und der Gruppe Vb (Vanadium, Niob, Tantal) oder VIb (Chrom, Molybdän, Wolfram) verwendet werden. Es werden auch Hartstoffschichten mit eingelagerten farbigen Metalloxiden oder farbige Metalloxide allein eingesetzt. Die Hartstoffschicht besteht im wesentlichen aus einem Nitrid, Karbid, Oxynitrid, Borid eines Elementes der Gruppe IVb, Vb oder VIb des Periodensystems oder des Aluminiums oder deren Mischungen; auch kann eine Hartstoffschicht, die im wesentlichen harten Kohlenstoff iC enthält, verwendet werden.

Es kann auch gleichzeitig zum Sputtern des Goldes oder eines anderen Materials eine Ionenplattierung erfolgen, worauf sich als Dekorschicht **7** eine Mischschicht bildet.

Zur Erzeugung einer schwarzen Dekorschicht kann z. B. entsprechend der EP-A 039 46 61 "Verfahren zur wenigstens teilweisen Beschichtung von Werkstücken mittels eines Sputter-CVD-Verfahrens" vorgegangen werden.

Anstelle einer Aluminiumoxidschicht $Al_2O_3$ als Trennschicht **9** kann auch eine Siliziumnitridschicht $Si_3N_4$ aufgebracht werden. Hierbei wird nur Silizium in den Tiegel **30** gegeben. Der Niedervoltbogen **52** wird gezündet und brennt von der Glühkathode **22** zum Silizium im Tiegel **30** mit einer 80genspannung von 90 V und einem Strom von 60 A, wobei bei Erreichen des Schmelzpunktes die Spannung auf 70 V abfällt und der Strom auf 200 A aufgrund der sich mit der Temperatur erhöhenden Leitfähigkeit des Siliziums anstiegt.

In einem folgenden ersten Verfahrensschritt wird die Stromstärke des Niedervoltbogens **52** auf 200 A bei einer Bogenspannung von 70 V gehalten. Hierdurch wird das Silizium aus dem Tiegel **30** in den gasförmigen Zustand überführt und teilweise ionisiert.

In einem zweiten Verfahrensschritt wird in die beim Reinigungsvorgang verwendete Argonatmosphäre Stickstoff durch die Gaszuleitung **39** eingelassen, der durch den Niedervoltbogen **52** teilweise ionisiert wird. Gleichzeitig wird die Blende **34** vor den Grundkörpern **3** weggeklappt. Der teilweise ionisierte Stickstoff und das teilweise ionisierte Silizium vereinigen sich auf der Oberfläche der Grundkörper **3** zu $Si_3N_4$ und bleiben auf ihr haften. Auch während dieses Verfahrensschritts rotieren die Grundkörper **3**.

Während dieses zweiten Verfahrensschrittes beträgt der Partialdruck des Argons $4 \cdot 10^{-2}$ Pa und der des Stickstoffs $3 \cdot 10^{-2}$ Fa. An den Trägern **35** liegt eine pulsierende Gleichspannung mit einer Periodendauer von 10 μs. Zu Beginn dieses Verfahrensschrittes liefert der Spannungsgenerator **48** negative Pulse mit einer Pulsbreite von 8 μs und einer Amplitude von - 200 V. In den folgenden 2 μs sind die Träger **35** über den Spannungsgenerator **48** geerdet. Während dieses Verfahrensschrittes wird die Amplitude derart zu kleineren negativen Werten verändert, daß sie gegen Ende bei - 10 V liegt.

Es kann auch das Material der keramischen Trennschicht **9** mit einem Elektronenstrahl, durch eine Kathodenzerstäubung (Sputtern), eine plasmaunterstütze Verdampfung oder eine kathodische Bogenverdampfung in den gasförmigen Zustand überführt werden.

Es kann auch eine Trennschicht **9** aus einem Oxid und/oder Nitrid eines Oxids eines Elements der Gruppe IVb (Titan, Zirkon, Hafnium), Vb (Vanadium, Niob, Tantal), VIb (Chrom, Molybdän, Wolfram) oder des Chroms oder aus Mischungen dieser Stoffe oder Mischungen dieser Stoffe mit einem Oxid, Nitrid oder Oxynitrids des Aluminiums erfolgen.

Anstelle den nicht mit der Leitung **47** verbundenen Pol des Spannungsgenerators **48** zu erden, kann er auch an den Tiegel **30** oder an Anodenpotential des Niedervoltbogens **52** angeschlossen werden. Anstelle die Pulshöhe von - 200 V auf - 10 V zu verändern, kann auch die Pulsbreite verkleinert werden; es kann auch die Pulshöhe und die Pulsbreite verändert werden.

Je nach Einsatz und Verwendung des beschichteten dekorativen Gegenstandes **1** kann auf die Hartstoffschicht **6**, wie in **Figur 5** dargestellt, verzichtet werden.

Die Dicke der Übergangsschicht **11** ist abhängig von der Verwendung des beschichteten Gegenstandes 3. Zur Vermeidung einer Scherwiderstandsreduktion kann es vorteilhaft sein die Übergangsschicht **11** ganz wegzulassen.

Bei einem zum Grundkorper **3** analogen Grundkorper **3b** aus Messing befindet sich, wie in **Figur 2** dargestellt, eine galvanische Schicht **16** mit einer Schichtdicke von 2 µm aus Nickel direkt auf der Oberfläche des Grundkörpers **3b**. Die galvanische Schicht **16** wird auf die Oberfläche des Grundkörpers **3b** unmittelbar nach dessen Fertigstellung und Oberfächenreinigung aufgebracht, um ein späteres Anlaufen während des Fertigungs- und Transportvorgangs zu vermeiden. Über dieser galvanischen Schicht **16** liegt eine der keramischen Trennschicht **9** entsprechende keramische Trennschicht **9b** und über dieser eine zu der Dekorschicht **7** entsprechende Dekorschicht **7b**.

Eine Beschichtung erfolgt hier analog zu den bereits oben geschilderten Verfahren mit dem Unterschied, daß hier nicht die Oberfläche des Grundkörpers **3**, sondern die auf ihn haftende galvanische Schicht **16** gereinigt wird.

Bei den erfindungsgemäß beschichteten Grundkörpern 3 erhöht die keramische Trennschicht **9** namentlich die Korrosionsbeständigkeit drastisch. Dieses Ergebnis ist namentlich insofern überraschend, als bis jetzt bei mittels PVD aufgebrachten Schichten gewöhnlich "pin holes", die einer Korrosionsbeständigkeit entgegenwirken, beobachtet wurden. Uhrenarmbänder und Uhrengehäuse z. B., welche eine nicht erfindungsgemäße Beschichtung, insbesondere ohne Trennschicht **9** aufweisen, haben einen ungenügenden Widerstand gegenüber korrosiven und abrasiven Beanspruchungen.

Da bei dem erfindungsgemäß beschichteten Grundkorper **3** die harte Schicht unterhalb der Dekorschicht **7** liegt, kann zwar bei einem harten Schlag auf den Grundkorper die Trennschicht **9** bzw. die Trennschicht **9** und die Hartstoffschicht **6** Risse erhalten. Diese Risse bleiben aber unsichtbar, da sie von der Dekorschicht **7** überdeckt werden. Das dekorative Aussehen wird somit nicht beeinflußt.

Das Aussehen beeinträchtigende Interferenzerscheinungen sind bei den erfindungsgemäß beschichteten Gegenständen nicht mehr vorhanden. Die Trennschicht **9** kann ausreichend dick hergestellt werden, wodurch ein ausreichender Korrosionsschutz erhalten wird.

Da die nach dem oben beschriebenen Verfahren beschichteten Gegenstände **1** eine ausgezeichnete Resistenz gegenüber Körperschweiß aufweisen und auch bei Langzeitversuchen im Salznebelsprühtest keine Schichtablösungen beachtet werden konnten, eignen sich die erfindungsgemäß beschichteten Gegenstände zum direkten Tragen auf der menschlichen Haut. Zur Erzielung einer langen Lebensdauer bei einwandfreier Oberflächenbeschaffenheit werden mit dem erfindungsgemäßen Verfahren bevorzugt Uhrenarmbänder bzw. Uhrengehäuse beschichtet.

## Ansprüche

1. Beschichteter Gegenstand **(1)** mit einer Dekorschicht **(7)** und einer Schicht **(9)** aus keramischem, elektrisch nicht leitendem Material, **dadurch gekennzeichnet**, daß die Dekorschicht **(7)** an der Außenseite der Beschichtung und die Schicht **(9)** aus keramischem, elektrisch nicht leitendem Material als Trennschicht zwischen der Dekorschicht **(7)** und dem Grundkörper **(3)** des Gegenstands **(1)** liegt.

2. Gegenstand **(1)** nach Anspruch 1, **dadurch gekennzeichnet**, daß die Trennschicht **(9)** röntgenamorph ist und insbesondere im wesentlichen aus einem Oxid, Nitrid oder Oxynitrid des Aluminiums besteht.

3. Gegenstand **(1)** nach einem der Ansprüche 1 oder 2, **dadurch gekennzeichnet**, daß die Trennschicht **(9)** eine mittels PVD erzeugte Schicht aus keramischem Material ist.

4. Gegenstand **(1)** nach einem der Ansprüche 1 bis 3, **dadurch gekennzeichnet**, daß die Trennschicht **(9)** eine Schichtdicke von annähernd 0,2 bis 1 µm hat.

5. Gegenstand **(1)** nach einem der Ansprüche 1 bis 5, **dadurch gekennzeichnet**, daß sowohl die Trennschicht **(9)** als auch die Dekorschicht **(7; 7b)** mittels PVD erzeugte Schichten im wesentlichen aus keramischem Material sind.

6. Gegenstand **(1)** nach einem der Ansprüche 1 bis 5, **gekennzeichnet durch** unmittelbar auf dem Grundkörper **(3)** befindliches Material des Bindungspartners des Oxids, Nitrids oder Oxynitrids der Trennschicht **(9)**, insbesondere im wesentlichen Aluminium, wobei die Materialzusammensetzung von der Oberfläche des Grundkörpers **(3)** allmählich in die der Trennschicht **(9)** übergeht.

7. Gegenstand **(1)** nach einem der Ansprüche 1 bis 6, **dadurch gekennzeichnet**, daß die Dekorschicht **(7)** im wesentlichen aus einer Hartstoffschicht **(6)** besteht.

8. Gegenstand **(1)** nach Anspruch 7, **dadurch gekennzeichnet**, daß die Hartstoffschicht **(6)** im wesentlichen aus Hartstoffen besteht, welche gebildet sind aus Sauerstoff und/oder Stickstoff und/oder Bor und/oder Kohlenstoff und/oder Silizium mit einem Metall aus der Spalte IVb des chemischen Periodensystems oder mit einer Legierung, deren Hauptbestandteil ein Element der Spalte IVb ist, und über der Hartstoffschicht **(6)** eine gegenüber dieser dünne farbtonbestimmende Schicht **(5)**, insbesondere aus einer Goldlegierung, liegt.

9. Gegenstand **(1)** nach Anspruch 7 oder 8, **gekennzeichnet durch** eine Übergangsschicht **(8)** zwischen der Hartstoff-**(6)** und der Trennschicht **(9)**, in der das Trennschichtmaterial allmählich in das Hartstoffmaterial übergeht.

10. Gegenstand **(1)** nach einem der Ansprüche 1 bis 5, **dadurch gekennzeichnet,** daß die Trennschicht **(9)** unmittelbar auf der Oberfläche des Grundkorpers **(3)** des Gegenstands **(1)** und die Dekorschicht **(7)** unmittelbar auf der Trennschicht **(9)** liegt.

11. Verfahren zur Herstellung der Beschichtung mit einem keramischen, elektrisch nicht leitenden Material auf einer Oberfläche eines gegenüber einer Vakuumkammer **(19)** isoliert gehaltenen Grundkörpers **(3)** gemäß einem der Ansprüche 1 bis 10, **dadurch gekennzeichnet,** daß in einem ersten Verfahrensschritt ein Oxid- und/oder Nitridbildner in den gasförmigen Zustand übergeführt und wenigstens teilweise ionisiert wird, in einem zweiten Verfahrensschritt Stickstoff und/oder Sauerstoff in die Vakuumkammer **(19)** eingeleitet und wenigstens teilweise ionisiert wird, worauf sich auf der Oberfläche des Grundkörpers **(3)** eine keramische Trennschicht **(9)** aus einer Verbindung des Oxid- bzw. Nitridbildners und des Stickstoffs und/oder des Sauerstoffs niederschlägt, auf die in einem dritten Verfahrensschritt eine Dekorschicht **(7)** niedergeschlagen wird.

12. Verfahren nach Anspruch 11, **dadurch gekennzeichnet,** daß zumindest während des zweiten Verfahrensschritts eine pulsierende Gleichspannung, an den Grundkörper **(3)** und/oder dessen Halter **(36)** gelegt wird.

13. Verfahren nach Anspruch 12, **dadurch gekennzeichnet,** daß die Pulshöhe der pulsierenden Gleichspannung beginnend mit einem hohen negativen Spannungswert auf einen geringen negativen Wert verändert und zwischen den Pulsen der Grundkörper **(3)** und/oder dessen Halter **(36)** geerdet oder auf das Potential des noch nicht in den gasförmigen Zustand überführten Oxid- bzw. Nitridbildners **(31)** oder auf Anodenpotential einer Bogenentladung **(52)** zur Überführung des Oxid- bzw. Nitridbildners **(31)** in den gasförmigen Zustand gelegt wird.

14. Verfahren nach einem der Ansprüche 11 bis 13, **dadurch gekennzeichnet,** daß zur Überführung des Oxid- und/oder Nitridbildners in den gasförmigen Zustand und zu dessen wenigstens teilweiser Ionisierung sowie zur wenigstens teilweisen Ionisierung des Stickstoffs und/oder Sauerstoffs eine Bogenentladung **(52)** verwendet wird.

15. Verfahren nach einem der Ansprüche 11 bis 14, **dadurch gekennzeichnet,** daß als Oxid- und/oder Nitridbildner für die Trennschicht **(9)** Aluminium verwendet wird.

16. Verwendung des Verfahrens nach einem der Ansprüche 11 bis 15 zur Beschichtung von Uhrengehäusen und/oder Uhrenarmbändern.

Fig. 5

Fig. 2

Fig. 4

Fig. 1

Fig. 3

## EINSCHLÄGIGE DOKUMENTE

| Kategorie | Kennzeichnung.des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | GB-A-2 162 864   (LEYBOLD HERAEUS)<br>* Ansprüche 1,8 *<br>— — — | 1,3,10,11, 16 | C 23<br>C 14/02<br>C 23 C 14/06 |
| A | US-A-4 428 808   (WEINERT et al.)<br>* Ansprüche 1,3 *<br>— — — | 2 | C 23 C 14/18<br>C 23 C 14/32 |
| A,D | FR-A-2 393 079   (BALZERS)<br>* Seite 3, Zeilen 19-40; Abbildung *<br>— — — | 11-14 | |
| A | GB-A-2 183 080   (RAYCHEM LTD)<br>* Zusammenfassung *<br>— — — | 6 | |
| A | GB-A-2 117 009   (CITIZEN WATCH CO.)<br>* Ansprüche 1,7,8 *<br>— — — — — | 5,7-9 | |

|  |
|---|
| **RECHERCHIERTE SACHGEBIETE (Int. Cl.5)**<br><br>C 23 C |

Der vorliegende Recherchenbericht wurde für alle Patentansprüche erstellt

| Recherchenort | Abschlußdatum der Recherche | Prüfer |
|---|---|---|
| Den Haag | 27 Februar 91 | PATTERSON A.M. |